# EUROPEAN PATENT APPLICATION

(11) **EP 4 394 865 A1**
(43) Date of publication of application: **03.07.2024**
(21) Application number: 23195062.7
(22) Date of filing: 04.09.2023
(51) Int. Cl.: H01L 23/498, H01L 23/538, H01L 25/065

(54) **DIE ATTACH IN GLASS CORE PACKAGE THROUGH ORGANIC-TO-ORGANIC BONDING**

(30) Priority: 29.12.2022 US 202218090707
(71) Applicant: Intel Corporation, Santa Clara, CA 95054 (US)
(72) Inventor: Shan, Bohan, Chandler, 85226 (US); Chen, Haobo, Chandler, 85249 (US); Nie, Bai, Chandler, 85249 (US); Pietambaram, Srinivas, Chandler, 85297 (US); Duan, Gang, Chandler, 85248 (US); Arrington, Kyle, Gilbert, 85297 (US); Lin, Ziyin, Chandler, 85226 (US); Feng, Hongxia, Chandler, 85249 (US); Bai, Yiqun, Chandler, 85249 (US); Guo, Xiaoying, Chandler, 85248 (US); Xu, Dingying, Chandler, 85248 (US); Darmawikarta, Kristof, Chandler, 85249 (US)
(74) Representative: Goddar, Heinz J.

(57) **Abstract**

An apparatus is provided which comprises: a plurality of interconnect layers within a substrate, a layer of organic dielectric material over the plurality of interconnect layers, copper pads within the layer of organic dielectric material, a first integrated circuit device copper-to-copper bonded with the copper pads, inorganic dielectric material over the layer of organic dielectric material, the inorganic dielectric material embedding the first integrated circuit device, and the inorganic dielectric material extending across a width of the substrate, and a second integrated circuit device coupled with a substrate surface above the inorganic dielectric material. Other embodiments are also disclosed and claimed.

## Description

### BACKGROUND

Computing platforms, such as desktops, laptops or smart phones, for example, are expected to have increased performance compared with previous iterations. One way that manufacturers of computing platforms can achieve increased performance is by integrating more integrated circuit devices into a single package. Heterogeneous integration refers to the integration of separately manufactured components into an assembly that, in the aggregate, provides enhanced functionality and improved operating characteristics. As more computing cores are integrated into a package, or system on a chip, there arises a need to integrate more memory components into the package as well. With increased integration, there can arise issues with warpage, power delivery, and thermal management within device packages. Therefore, there is a need for high performance architectures that address these issues.

### BRIEF DESCRIPTION OF THE DRAWINGS

The embodiments of the disclosure will be understood more fully from the detailed description given below and from the accompanying drawings of various embodiments of the disclosure, which, however, should not be taken to limit the disclosure to the specific embodiments, but are for explanation and understanding only.
**Fig. 1** illustrates a cross-sectional view of an example die attach in glass core package through organic-to-organic bonding, according to some embodiments,
**Figs. 2A-2F** illustrate cross-sectional views of example manufacturing steps of forming a die attach in glass core package through organic-to-organic bonding, according to some embodiments,
**Figs. 3A-3F** illustrate cross-sectional views of example manufacturing steps of forming a die attach in glass core package through organic-to-organic bonding, according to some embodiments,
**Fig. 4** illustrates a cross-sectional view of an example die attach in glass core package through organic-to-organic bonding, according to some embodiments,
**Fig. 5** illustrates a flowchart of a method of forming a die attach in glass core package through organic-to-organic bonding, in accordance with some embodiments, and
**Fig. 6** illustrates a smart device or a computer system or a SoC (System-on-Chip) which includes a die attach in glass core package through organic-to-organic bonding, according to some embodiments.

### DETAILED DESCRIPTION

Die attach in glass core package through organic-to-organic bonding is generally presented. In this regard, embodiments of the present disclosure enable embedded devices through organic-to-organic bonding, and thereby avoid having to form a cavity within dielectric material and also having to perform a die attach to a bottom surface of the cavity, which can be problematic. One skilled in the art would appreciate that this die attach may enable more complex, higher power, highly integrated devices. Additionally, the architectures described herein may offer improved thermal management, power delivery, and reliability, and thereby enable enhanced features.

In the following description, numerous details are discussed to provide a more thorough explanation of embodiments of the present disclosure. It will be apparent, however, to one skilled in the art, that embodiments of the present disclosure may be practiced without these specific details. In other instances, well-known structures and devices are shown in block diagram form, rather than in detail, in order to avoid obscuring embodiments of the present disclosure.

Throughout the specification, and in the claims, the term "connected" means a direct connection, such as electrical, mechanical, or magnetic connection between the things that are connected, without any intermediary devices. The term "coupled" means a direct or indirect connection, such as a direct electrical, mechanical, or magnetic connection between the things that are connected or an indirect connection, through one or more passive or active intermediary devices. The term "circuit" or "module" may refer to one or more passive and/or active components that are arranged to cooperate with one another to provide a desired function. The term "signal" may refer to at least one current signal, voltage signal, magnetic signal, or data/clock signal. The meaning of "a," "an," and "the" include plural references. The meaning of "in" includes "in" and "on."

Unless otherwise specified the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C). The terms "left," "right," "front," "back," "top," "bottom," "over," "under," and the like in the description and in the claims, if any, are used for descriptive purposes and not necessarily for describing permanent relative positions.

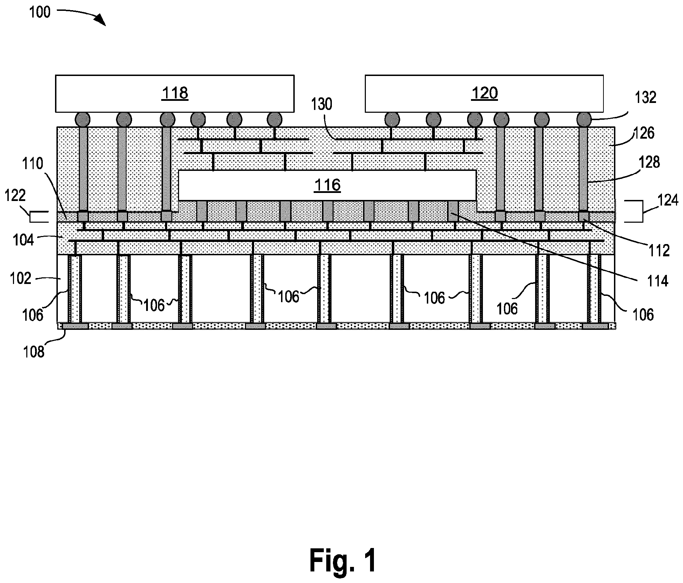

**Fig. 1** illustrates a cross-sectional view of an example die attach in a glass core package through organic-to-organic bonding, according to some embodiments. As shown, device package 100 includes glass core 102, interconnect layers 104, vias 106, conductive contacts 108, organic dielectric layer 110, copper contacts 112, copper contacts 114, embedded integrated circuit device 116, surface integrated circuit device 118, surface integrated circuit device 120, organic dielectric thickness 122, organic dielectric thickness 124, dielectric material 126, copper pillars 128, metal traces 130, and solder bumps 132. In some embodiments, device package 100 may include additional routing or interconnect layers, for example above or below glass core 102, or other components or features, not shown herein.

In some embodiments, glass core 102 may be a silicate (for example silicon dioxide-based) glass that may be tempered or treated. In some embodiments, glass core 102 is a non-crystalline amorphous solid. In some embodiments, glass core 102 may be designed to be thin and damage-resistant. In some embodiments, glass core 102 is pre-formed and not deposited in-situ using a traditional deposition technique, such as atomic layer deposition or chemical vapor deposition, for example. In some embodiments, glass core 102 is made by fusing liquid sand with soda ash (sodium carbonate), limestone (calcium carbonate), and/or other ingredients and cooling rapidly. In some embodiments, glass core 102 may contain boron oxide for improved thermal resistance. In some embodiments, glass core 102 may contain lead oxide for improved ease of cutting. In some embodiments, glass core 102 may contain a sandwich or laminate of multiple layers of glass that are plastic bonded together. In some embodiments, glass core 102 is transparent or translucent. In some embodiments, glass core 102 may have a thickness of between about 100 micrometers and 10 millimeters. Glass core 102 may have an inherently low surface roughness and a high temperature tolerance, allowing for uniform thin film depositions that require annealing. In some embodiments, glass core 102 may have a relatively low coefficient of thermal expansion (CTE). In some embodiments, glass core 102 may also contain ceramic material. In some embodiments, the thermal expansion of glass core 102 is controlled by firing to create crystalline species that will influence the overall expansion of glass core 102 in the desired direction. For example, glass core 102 may include crystalline additives that tend to thermally expand longitudinally, as opposed to laterally. In some embodiments, the formulation of glass core 102 employs materials delivering particles of the desired expansion to the matrix. In some embodiments, glass core 102 may include a glaze (not shown) that may have the effect of reducing thermal expansion.

Interconnect layers 104 may be formed over glass core 102. In some embodiments, interconnect layers 104 may include multiple layers of interlayer dielectric, such as organic dielectric build-up films over an adhesion promoting layer of doped silicon dioxide, for example, along with metal wires to route contacts of vias 106 to embedded integrated circuit device 116 and surface integrated circuit devices 118 and 120. In some embodiments, interconnect layers 104 may fan-in a contact pitch from vias 106 to embedded integrated circuit device 116. Copper contacts 114 may conductively couple embedded integrated circuit device 116 with interconnect layers 104.

Vias 106 may be drilled through glass core 102 by any known method, including, for example, laser drilling, etching and plating, to provide electrical pathways through glass core 102 from conductive contacts 108 to interconnect layers 104. Vias 106, which may commonly be referred to as a through-glass via (TGV), after being plated with copper, may also be filled with additional dielectric material to provide electrical insulation in some embodiments.

Organic dielectric layer 110 represents any type of organic dielectric material. In some embodiments, organic dielectric layer 110 is a photo imageable dielectric, such as a photosensitive polyimide, for example. In other embodiments, organic dielectric layer 110 is a non-photosensitive organic dielectric material. In some embodiments, organic dielectric layer 110 is split coated or spray coated over interconnect layers 104, however, any known deposition method may be used. In some embodiments, organic dielectric layer 110 may be a positive tone or a negative tone photosensitive polyimide that is patterned to form openings in which copper contacts 112 and 114 are plated. In some embodiments, where organic dielectric layer 110 is a non-photosensitive dielectric material, copper contacts 112 and 114 may first be plated and then organic dielectric layer 110 may be coated over copper contacts 112 and 114, before chemical mechanical polishing (CMP) may be utilized to reveal copper contacts 112 and 114.

In some embodiments, embedded integrated circuit device 116 is hybrid bonded through organic-to-organic and copper-to-copper bonds to organic dielectric layer 110 and copper contacts 114. In some embodiments, embedded integrated circuit device 116 may be a bridge device that communicatively couples surface integrated circuit devices 118 and 120. In some embodiments, organic dielectric thickness 124, below embedded integrated circuit device 116, is approximately double organic dielectric thickness 122 and copper contacts 114, below embedded integrated circuit device 116 are approximately twice as tall as copper contacts 112. While shown as being communicatively coupled with both integrated circuit devices 118 and 120 through metal traces 130, in some embodiments, embedded integrated circuit device 116 may be communicatively coupled with more or fewer included integrated circuit devices through metal traces 130 and/or copper contacts 114.

In some embodiments, embedded integrated circuit device 116 may be a memory device, such as a high bandwidth memory (HBM). In some embodiments, embedded integrated circuit device 116 may be an intelligent power device (IPD). In other embodiments, embedded integrated circuit device 116 may be a photonic integrated circuit (PIC) or an embedded passive component (EPC). While shown as being a single device, embedded integrated circuit device 116 may be implemented as a stack of multiple homogeneous or heterogeneous devices.

In some embodiments, surface integrated circuit devices 118 and 120 may be heterogeneous or homogeneous devices. In some embodiments, one of surface integrated circuit devices 118 and 120 is a processor, such as one or more controllers, or system-on-a-chip (SOCs), or multi-core processor, for example, and the other is a memory, such as a high bandwidth memory, however any number and type of surface integrated circuit devices may be present.

In some embodiments, dielectric material 126 may be a mold to encapsulate integrated circuit device 116. In some embodiments, dielectric material 126 may be made of multiple materials and/or layers, including, for example, silicon oxide that is deposited over embedded integrated circuit device 116 and extends a complete length of device package 100. In some embodiments, copper pillars 128 may be present and couple with surface integrated circuit devices 118 and 120. In other embodiments, copper pillars 128 may not extend as far, for example, extending to an upper surface of embedded integrated circuit device 116. In some embodiments, metal traces 130 may couple one or both of surface integrated circuit devices 118 and 120 with embedded integrated circuit device 116, and may represent copper plating. While shown as being bonded with solder bumps 132, surface integrated circuit devices 118 and 120 may be bonded through any known method, including hybrid bonding.

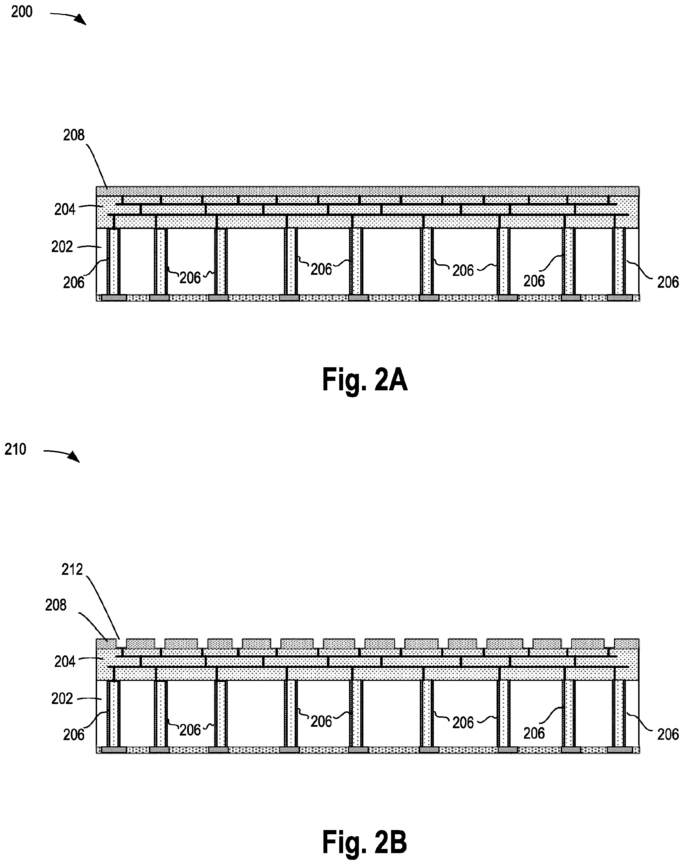

**Figs. 2A-2F** illustrate cross-sectional views of example manufacturing steps of forming a die attach in a glass core package through organic-to-organic bonding, according to some embodiments. As shown in Fig. 2A, assembly 200 includes glass core 202, interconnect layers 204, vias 206, and organic dielectric layer 208. In some embodiments, vias 206 may be drilled through glass core 202 and then plated and insulated. In some embodiments, interconnect layers 204 are iterative layers of copper and inorganic dielectric material, such as silicon oxide. In some embodiments, organic dielectric layer 208 may be a preformed film or deposited by any known technique, such as spray coating, for example.

Fig. 2B shows assembly 210, which may include openings 212 in organic dielectric layer 208. In some embodiments, openings 212 are formed through a photolithography process including depositing a resist layer (not shown). In some embodiments, organic dielectric layer 208 may be a positive tone or a negative tone photosensitive polyimide.

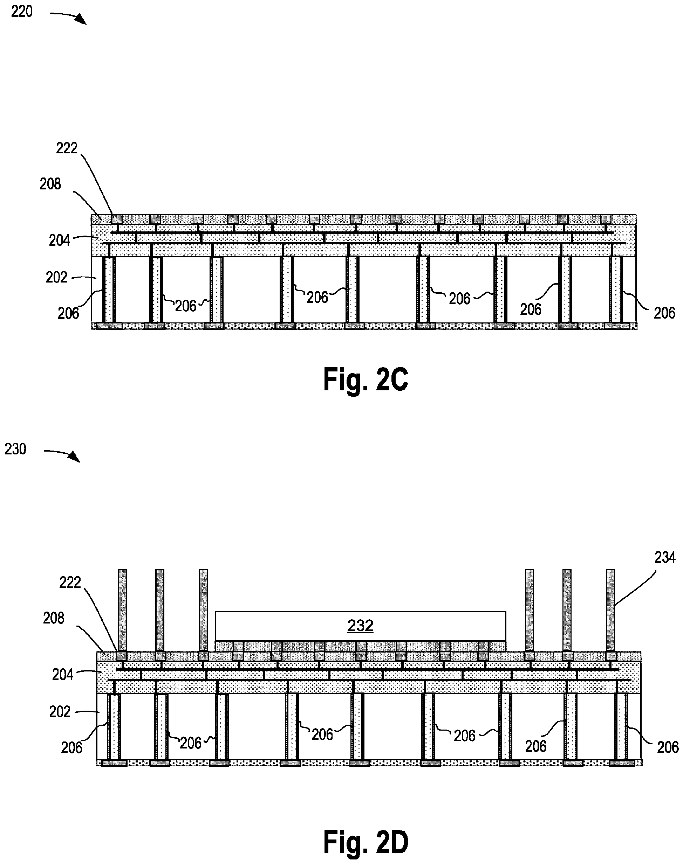

As shown in Fig. 2C, assembly 220 may include copper contacts 222 in organic dielectric layer 208. In some embodiments, copper contacts 222 may be electro or electroless plated. In some embodiments, copper contacts 222 may have been over-plated over organic dielectric layer 208 and may have required chemical mechanical polishing to reveal organic dielectric layer 208.

Turning now to Fig. 2D, assembly 230 may include integrated circuit device 232 and copper pillars 234. In some embodiments, integrated circuit device 232 may include copper contacts and organic dielectric material that are placed in alignment with copper contacts 222 and organic dielectric layer 208. In some embodiments, copper pillars 234 may be formed through additional photolithography steps including depositing and removing material not shown.

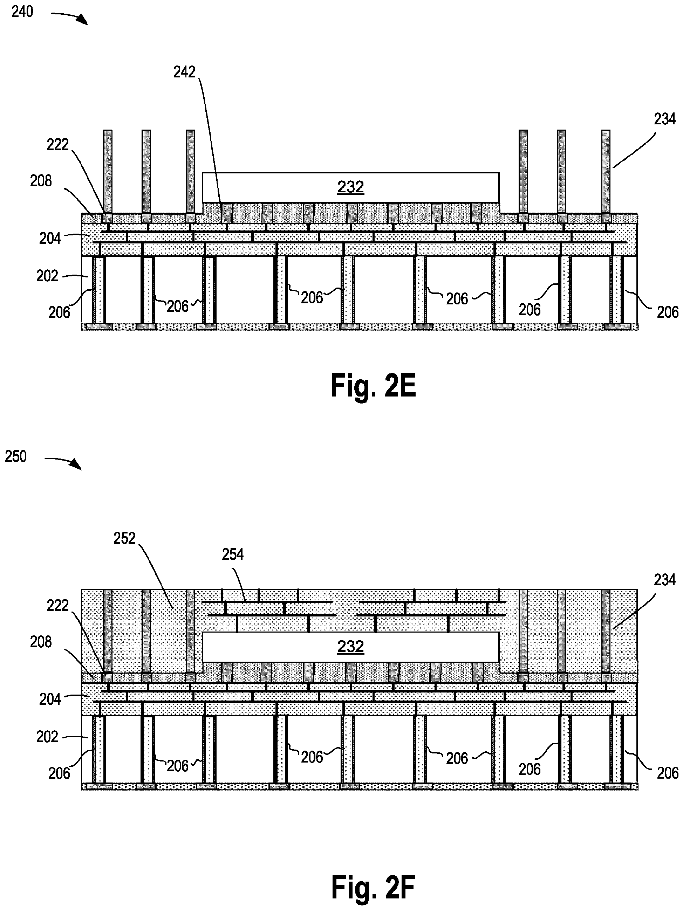

Fig. 2E shows assembly 240, which may include copper bonds 242 in organic dielectric layer 208. In some embodiments, copper bonds 242 may be copper-to-copper bond that may be formed in one or multiple steps involving pressure and/or heat. In some embodiments, copper bonds 242 may have straight sidewalls that are slightly offset near the middle. In some embodiments, copper bonds 242 may have a pitch of less than about 10 micrometers.

As shown in Fig. 2F, assembly 250 may include dielectric material 252 and conductive traces 254. In some embodiments, dielectric material 252 and conductive traces 254 may be built-up over multiple layering iterations and may include mold compound and/or silicon oxide with copper plating.

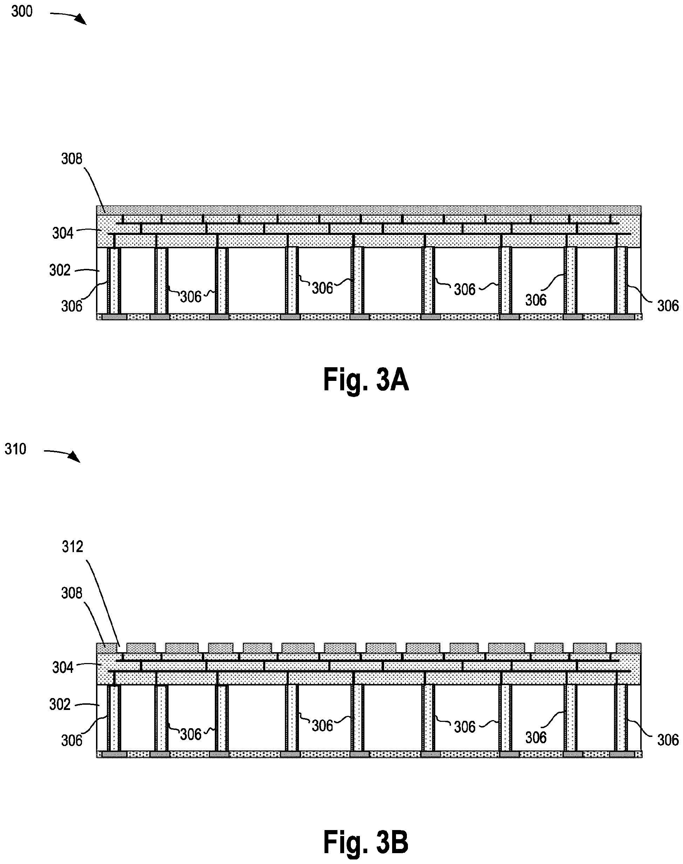

**Figs. 3A-3F** illustrate cross-sectional views of example manufacturing steps of forming a die attach in a glass core package through organic-to-organic bonding, according to some embodiments. As shown in Fig. 3A, assembly 300 includes glass core 302, interconnect layers 304, vias 306, and organic dielectric layer 308. In some embodiments, vias 306 may be drilled through glass core 302 and then plated and insulated. In some embodiments, interconnect layers 304 are iterative layers of copper and inorganic dielectric material, such as silicon oxide. In some embodiments, organic dielectric layer 308 may be a preformed film or spun-on deposition.

Fig. 3B shows assembly 310, which may include openings 312 in organic dielectric layer 308. In some embodiments, openings 312 are formed through a photolithography process including depositing a resist layer (not shown). In some embodiments, organic dielectric layer 308 may be a positive tone or a negative tone photosensitive polyimide.

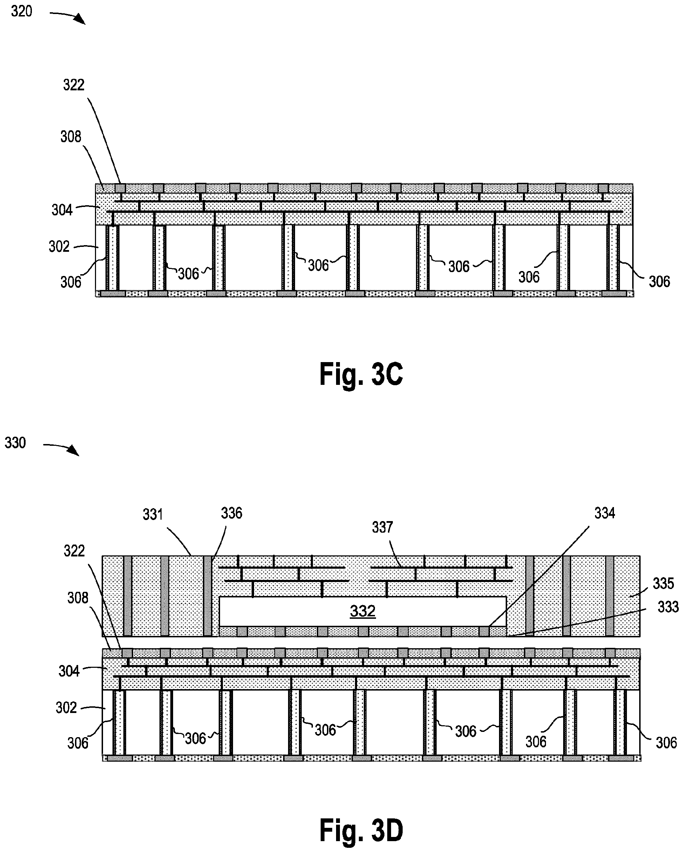

As shown in Fig. 3C, assembly 320 may include copper contacts 322 in organic dielectric layer 308. In some embodiments, copper contacts 322 may be electro or electroless plated and may or may not require chemical mechanical polishing to reveal organic dielectric layer 308 and create a smooth surface for hybrid bonding.

Turning now to Fig. 3D, assembly 330 may include device assembly 331, integrated circuit device 332, organic dielectric layer 333, copper contacts 334, dielectric material 335, copper pillars 336, and metal traces 337. In some embodiments, device assembly 331 may include copper contacts 334 and organic dielectric layer 333 that are placed in alignment with copper contacts 322 and organic dielectric layer 308, respectively. In some embodiments integrated circuit device 332 may have active contacts on both opposite surfaces, while in other embodiments, only the surface coupled with metal traces 337 are active contacts. While shown as including copper pillars 336 within dielectric material 335, in some embodiments, additional metal traces 337 may be present instead of copper pillars 336 to route signals through device assembly 331.

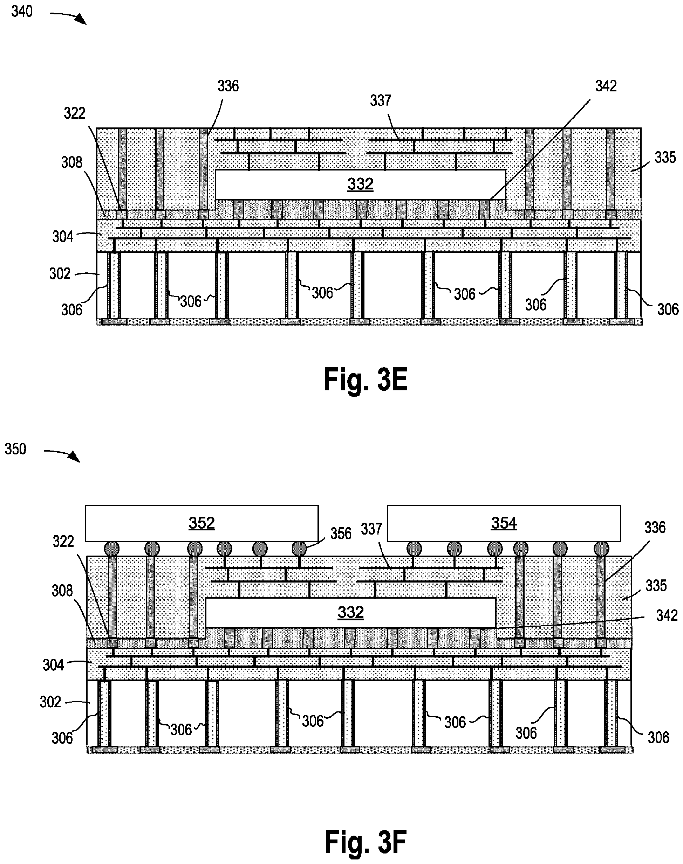

Fig. 3E shows assembly 340, which may include copper bonds 342 in organic dielectric layer 308. In some embodiments, copper bonds 342 may be copper-to-copper bonds that may be formed in one or multiple steps involving pressure and/or heat. In some embodiments, copper bonds 342 may have straight sidewalls that are slightly offset near the middle.

As shown in Fig. 3F, assembly 350 may include surface integrated circuit devices 352 and 354 coupled with assembly 350 through solder bumps 356. In some embodiments, surface integrated circuit devices 352 and 354 may be heterogeneous devices, such as a processor and memory, that are communicatively coupled through integrated circuit device 332, such as a bridge device. In some embodiments, solder bumps 356 may be lead or leadfree bumps or another type of connection technology.

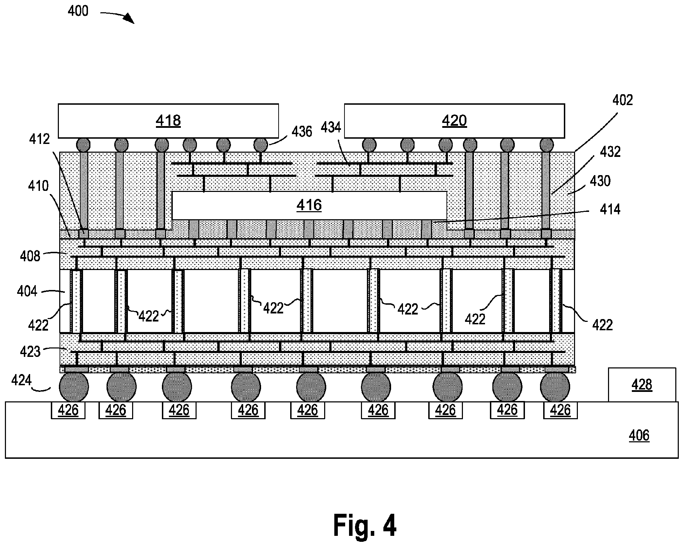

**Fig. 4** illustrates a cross-sectional view of an example die attach in a glass core package through organic-to-organic bonding, according to some embodiments. As shown, assembly 400 includes device package 402, glass core 404, system board 406, interconnect layers 408, organic dielectric layer 410, copper contacts 412, copper bonds 414, embedded integrated circuit device 416, surface integrated circuit device 418, surface integrated circuit device 420, vias 422, buildup layers 423, solder balls 424, board pads 426, board component 428, dielectric material 430, copper pillars 432, metal traces 434, and solder bumps 436.

Device package 402 may incorporate elements previously discussed in reference to prior figures. For example, elements of device package 402 may have properties discussed in reference to Figs. 1, 2A-2F, or 3A-3F. As shown, device package 402 may include surface integrated circuit devices 418 and 420 which are communicatively coupled with each other through embedded integrated circuit 416. In this example embodiment, embedded integrated circuit device 416 may be hybrid bonded through copper bonds 414 and organic-to-organic bonds with organic dielectric layer 410. In some embodiments, buildup layers 423 may represent approximately three to ten layers of interconnect buildup layers of dielectric material and metal traces. In some embodiments, device package 402 may include additional routing or interconnect layers, for example above or below glass core 404, or other components or features, not shown herein.

In some embodiments, solder balls 424 may be formed on a bottom surface of device package 402 thereby allowing device package 402 to be soldered to system board 406 through board pads 426. System board 406 may also incorporate board component 428, which may represent any type of active or passive system components, such as a power supply, memory devices, voltage regulators, I/O interfaces, etc.

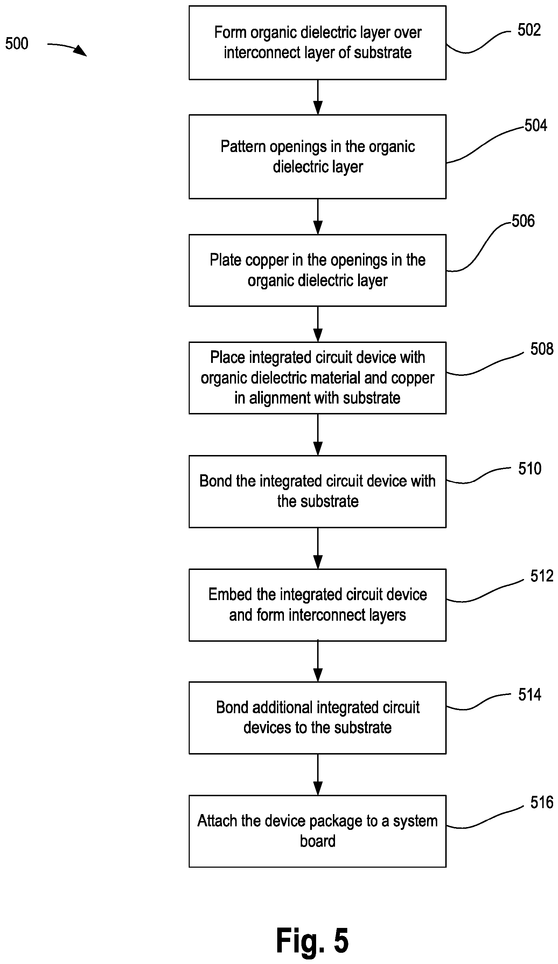

**Fig.** 5 illustrates a flowchart of a method of forming a die attach in a glass core package through organic-to-organic bonding, in accordance with some embodiments. Although the blocks in the flowchart with reference to **Fig. 5** are shown in a particular order, the order of the actions can be modified. Thus, the illustrated embodiments can be performed in a different order, and some actions/blocks may be performed in parallel. Some of the blocks and/or operations listed in **Fig. 5** are optional in accordance with certain embodiments. The numbering of the blocks presented is for the sake of clarity and is not intended to prescribe an order of operations in which the various blocks must occur. Additionally, operations from the various flows may be utilized in a variety of combinations.

Method 500 begins with forming (502) an organic dielectric layer over an interconnect layer of a substrate. In some embodiments, such as assembly 200, organic dielectric layer 208 may be deposited over interconnect layers 204. Next, the organic dielectric layer may be patterned (504) to create openings. In some embodiments, such as assembly 210, openings 212 may be formed in organic dielectric layer 208 through photolithographic processes.

Then, copper may be plated (506) in the openings in the organic dielectric layer. In some embodiments, such as assembly 220, copper contacts 222 may fill the openings 212 in organic dielectric layer 208. Next, an integrated circuit device may be placed (508) with organic dielectric material and copper in alignment with the substrate. In some embodiments, such as assembly 230, integrated circuit device 232 may be placed in alignment with copper contacts 222. In other embodiments, such as assembly 330, device assembly 331 may be placed in alignment with copper contacts 322.

The method continues, in some embodiments, with bonding (510) the integrated circuit device with the substrate. In some embodiments, such as assembly 240, copper bonds 242 may be formed below integrated circuit device 232. Next, the integrated circuit device may be embedded (512) and interconnect layers may be formed. In some embodiments, such as assembly 250, inorganic dielectric material 252 may embed integrated circuit device 232 and surround metal traces 254 above integrated circuit device 232.

Next, additional integrated circuit devices may be bonded (514) to the substrate. In some embodiments, such as device package 100, surface integrated circuit devices 118 and 120 may be bonded to device package 100 through solder bumps 132 and may be communicatively coupled with each other through embedded integrated circuit device 116. Finally, the device package may be attached (516) to a system board. In some embodiments, solder bumps, such as solder bumps 424 may be formed on device package 402, allowing device package 402 to be soldered to system board 406.

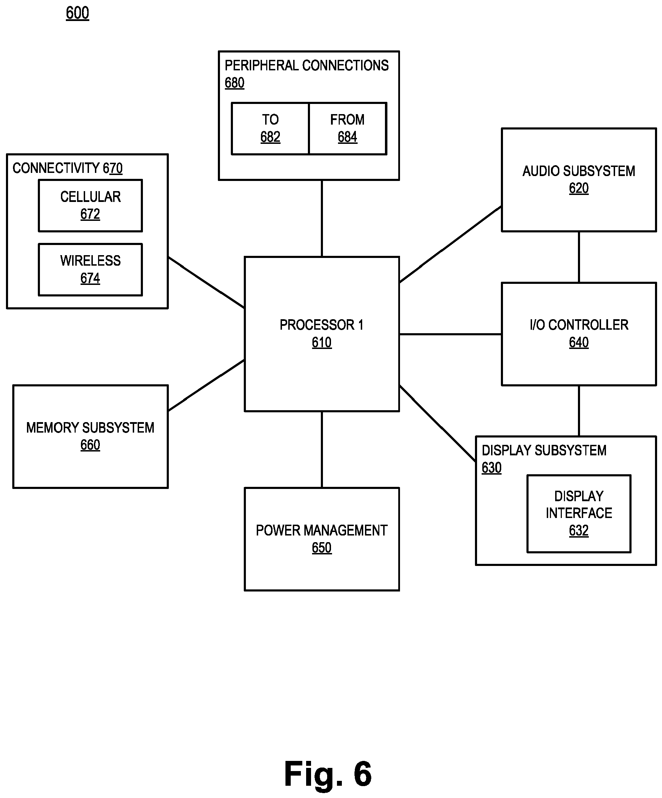

**Fig. 6** illustrates a smart device or a computer system or a SoC (System-on-Chip) which includes a die attach in a glass core package through organic-to-organic bonding, according to some embodiments. In some embodiments, computing device 600 represents a mobile computing device, such as a computing tablet, a mobile phone or smart-phone, a wireless-enabled e-reader, or other wireless mobile device. It will be understood that certain components are shown generally, and not all components of such a device are shown in computing device 600. In some embodiments, one or more components of computing device 600, for example processor 610 or I/O controller 640, include a die attach in a glass core package through organic-to-organic bonding as described above.

For purposes of the embodiments, the transistors in various circuits and logic blocks described here are metal oxide semiconductor (MOS) transistors or their derivatives, where the MOS transistors include drain, source, gate, and bulk terminals. The transistors and/or the MOS transistor derivatives also include Tri-Gate and FinFET transistors, Gate All Around Cylindrical Transistors, Tunneling FET (TFET), Square Wire, or Rectangular Ribbon Transistors, ferroelectric FET (FeFETs), or other devices implementing transistor functionality like carbon nanotubes or spintronic devices. MOSFET symmetrical source and drain terminals i.e., are identical terminals and are interchangeably used here. A TFET device, on the other hand, has asymmetric Source and Drain terminals. Those skilled in the art will appreciate that other transistors, for example, Bi-polar junction transistors-BJT PNP/NPN, BiCMOS, CMOS, etc., may be used without departing from the scope of the disclosure.

In some embodiments, computing device 600 includes a first processor 610. The various embodiments of the present disclosure may also comprise a network interface within 670 such as a wireless interface so that a system embodiment may be incorporated into a wireless device, for example, cell phone or personal digital assistant.

In one embodiment, processor 610 can include one or more physical devices, such as microprocessors, application processors, microcontrollers, programmable logic devices, or other processing means. The processing operations performed by processor 610 include the execution of an operating platform or operating system on which applications and/or device functions are executed. The processing operations include operations related to I/O (input/output) with a human user or with other devices, operations related to power management, and/or operations related to connecting the computing device 600 to another device. The processing operations may also include operations related to audio I/O and/or display I/O.

In one embodiment, computing device 600 includes audio subsystem 620, which represents hardware (e.g., audio hardware and audio circuits) and software (e.g., drivers, codecs) components associated with providing audio functions to the computing device. Audio functions can include speaker and/or headphone output, as well as microphone input. Devices for such functions can be integrated into computing device 600, or connected to the computing device 600. In one embodiment, a user interacts with the computing device 600 by providing audio commands that are received and processed by processor 610.

Display subsystem 630 represents hardware (e.g., display devices) and software (e.g., drivers) components that provide a visual and/or tactile display for a user to interact with the computing device 600. Display subsystem 630 includes display interface 632, which includes the particular screen or hardware device used to provide a display to a user. In one embodiment, display interface 632 includes logic separate from processor 610 to perform at least some processing related to the display. In one embodiment, display subsystem 630 includes a touch screen (or touch pad) device that provides both output and input to a user.

I/O controller 640 represents hardware devices and software components related to interaction with a user. I/O controller 640 is operable to manage hardware that is part of audio subsystem 620 and/or display subsystem 630. Additionally, I/O controller 640 illustrates a connection point for additional devices that connect to computing device 600 through which a user might interact with the system. For example, devices that can be attached to the computing device 600 might include microphone devices, speaker or stereo systems, video systems or other display devices, keyboard or keypad devices, or other I/O devices for use with specific applications such as card readers or other devices.

As mentioned above, I/O controller 640 can interact with audio subsystem 620 and/or display subsystem 630. For example, input through a microphone or other audio device can provide input or commands for one or more applications or functions of the computing device 600. Additionally, audio output can be provided instead of, or in addition to display output. In another example, if display subsystem 630 includes a touch screen, the display device also acts as an input device, which can be at least partially managed by I/O controller 640. There can also be additional buttons or switches on the computing device 600 to provide I/O functions managed by I/O controller 640.

In one embodiment, I/O controller 640 manages devices such as accelerometers, cameras, light sensors or other environmental sensors, or other hardware that can be included in the computing device 600. The input can be part of direct user interaction, as well as providing environmental input to the system to influence its operations (such as filtering for noise, adjusting displays for brightness detection, applying a flash for a camera, or other features).

In one embodiment, computing device 600 includes power management 650 that manages battery power usage, charging of the battery, and features related to power saving operation. Memory subsystem 660 includes memory devices for storing information in computing device 600. Memory can include nonvolatile (state does not change if power to the memory device is interrupted) and/or volatile (state is indeterminate if power to the memory device is interrupted) memory devices. Memory subsystem 660 can store application data, user data, music, photos, documents, or other data, as well as system data (whether long-term or temporary) related to the execution of the applications and functions of the computing device 600.

Elements of embodiments are also provided as a machine-readable medium (e.g., memory 660) for storing the computer-executable instructions. The machine-readable medium (e.g., memory 660) may include, but is not limited to, flash memory, optical disks, CD-ROMs, DVD ROMs, RAMs, EPROMs, EEPROMs, magnetic or optical cards, phase change memory (PCM), or other types of machine-readable media suitable for storing electronic or computer-executable instructions. For example, embodiments of the disclosure may be downloaded as a computer program (e.g., BIOS) which may be transferred from a remote computer (e.g., a server) to a requesting computer (e.g., a client) by way of data signals via a communication link (e.g., a modem or network connection).

Connectivity 670 includes hardware devices (e.g., wireless and/or wired connectors and communication hardware) and software components (e.g., drivers, protocol stacks) to enable the computing device 600 to communicate with external devices. The computing device 600 could be separate devices, such as other computing devices, wireless access points or base stations, as well as peripherals such as headsets, printers, or other devices.

Connectivity 670 can include multiple different types of connectivity. To generalize, the computing device 600 is illustrated with cellular connectivity 672 and wireless connectivity 674. Cellular connectivity 672 refers generally to cellular network connectivity provided by wireless carriers, such as provided via GSM (global system for mobile communications) or variations or derivatives, CDMA (code division multiple access) or variations or derivatives, TDM (time division multiplexing) or variations or derivatives, or other cellular service standards. Wireless connectivity (or wireless interface) 674 refers to wireless connectivity that is not cellular, and can include personal area networks (such as Bluetooth, Near Field, etc.), local area networks (such as Wi-Fi), and/or wide area networks (such as WiMax), or other wireless communication.

Peripheral connections 680 include hardware interfaces and connectors, as well as software components (e.g., drivers, protocol stacks) to make peripheral connections. It will be understood that the computing device 600 could both be a peripheral device ("to" 682) to other computing devices, as well as have peripheral devices ("from" 684) connected to it. The computing device 600 commonly has a "docking" connector to connect to other computing devices for purposes such as managing (e.g., downloading and/or uploading, changing, synchronizing) content on computing device 600. Additionally, a docking connector can allow computing device 600 to connect to certain peripherals that allow the computing device 600 to control content output, for example, to audiovisual or other systems.

In addition to a proprietary docking connector or other proprietary connection hardware, the computing device 600 can make peripheral connections 680 via common or standards-based connectors. Common types can include a Universal Serial Bus (USB) connector (which can include any of a number of different hardware interfaces), DisplayPort including MiniDisplayPort (MDP), High Definition Multimedia Interface (HDMI), Firewire, or other types.

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included. If the specification or claim refers to "a" or "an" element, that does not mean there is only one of the elements. If the specification or claims refer to "an additional" element, that does not preclude there being more than one of the additional element.

Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive

While the disclosure has been described in conjunction with specific embodiments thereof, many alternatives, modifications and variations of such embodiments will be apparent to those of ordinary skill in the art in light of the foregoing description. The embodiments of the disclosure are intended to embrace all such alternatives, modifications, and variations as to fall within the broad scope of the appended claims.

In addition, well known power/ground connections to integrated circuit (IC) chips and other components may or may not be shown within the presented figures, for simplicity of illustration and discussion, and so as not to obscure the disclosure. Further, arrangements may be shown in block diagram form in order to avoid obscuring the disclosure, and also in view of the fact that specifics with respect to implementation of such block diagram arrangements are highly dependent upon the platform within which the present disclosure is to be implemented (i.e., such specifics should be well within purview of one skilled in the art). Where specific details (e.g., circuits) are set forth in order to describe example embodiments of the disclosure, it should be apparent to one skilled in the art that the disclosure can be practiced without, or with variation of, these specific details. The description is thus to be regarded as illustrative instead of limiting.

The following examples pertain to further embodiments. Specifics in the examples may be used anywhere in one or more embodiments. All optional features of the apparatus described herein may also be implemented with respect to a method or process.

An abstract is provided that will allow the reader to ascertain the nature and gist of the technical disclosure. The abstract is submitted with the understanding that it will not be used to limit the scope or meaning of the claims. The following claims are hereby incorporated into the detailed description, with each claim standing on its own as a separate embodiment.

## Claims

1. A method comprising:
depositing organic dielectric material over interconnect layers of a package substrate;
patterning the organic dielectric material to form openings;
depositing copper in the openings to form contacts;
aligning copper pads of a first integrated circuit device with the copper contacts in the organic dielectric material;
bonding the copper pads with the copper contacts;
depositing inorganic dielectric material over the first integrated circuit device, the inorganic dielectric material extending across a width of the package substrate; and/or
bonding a second integrated circuit device with a surface above the inorganic dielectric material.

2. The method of claim 1, wherein depositing organic dielectric material comprises depositing photosensitive polyimide dielectric material.

3. The method of claim 1, further comprising bonding a third integrated circuit device with the surface above the inorganic dielectric material, wherein the second and third integrated circuit devices are communicatively coupled through the first integrated circuit device.

4. The method of any preceding claim, further comprising:
forming copper traces within the inorganic dielectric material to couple the second integrated circuit device with the first integrated circuit device; and/or
forming the interconnect layers over a glass core of the package substrate; and/or
forming a plurality of copper pillars on the organic dielectric material.

5. An apparatus produced by a method as claimed in any preceding claim.

6. The apparatus of claim 5, further comprising:
a plurality of interconnect layers within a substrate;
a layer of organic dielectric material over the plurality of interconnect layers;
copper pads within the layer of organic dielectric material;
a first integrated circuit device copper-to-copper bonded with the copper pads;
inorganic dielectric material over the layer of organic dielectric material, the inorganic dielectric material embedding the first integrated circuit device, and the inorganic dielectric material extending across a width of the substrate; and/or
a second integrated circuit device coupled with a substrate surface above the inorganic dielectric material.

7. The apparatus of claim 6, wherein the layer of organic dielectric material comprises a photo imageable dielectric.

8. The apparatus of claim 6, wherein the layer of organic dielectric material comprises a polyimide.

9. The apparatus of claim 6, wherein the embedded integrated circuit device comprises a bridge device that communicatively couples the second integrated circuit device with a third integrated circuit device.

10. The apparatus of claim 6, wherein the second integrated circuit device comprises a processor and the third integrated circuit device comprises a memory device.

11. The apparatus of claim 6, further comprising:
a glass core coupled with the plurality of interconnect layers; and/or
a plurality of copper pillars within the inorganic dielectric material, the plurality of copper pillars coupled with the plurality of interconnect layers.

12. The apparatus of claim 6, wherein the organic dielectric comprises a first thickness below the embedded integrated circuit device and a second thickness elsewhere, the first thickness being greater than the second thickness.

13. The apparatus of claim 6, wherein the embedded integrated circuit device comprises a device chosen from the group consisting of high bandwidth memory (HBM), intelligent power device (IPD), photonic integrated circuit (PIC), and embedded passive components (EPC).

14. The apparatus of claim 6, wherein the dielectric material comprises silicon oxide.

15. The apparatus of any preceding claim further comprising comprising:
a host board; and/or
a power supply to provide power to an integrated circuit device package through the host board.
